Europäisches Patentamt

European Patent Office

Office européen des brevets

(11) Numéro de publication : **0 406 051 B1**

(12) # FASCICULE DE BREVET EUROPEEN

(45) Date de publication du fascicule du brevet :
**31.08.94 Bulletin 94/35**

(51) Int. Cl.[5] : **G11B 5/37, H01L 43/06**

(21) Numéro de dépôt : **90401670.6**

(22) Date de dépôt : **15.06.90**

(54) **Tête de lecture magnétique à effet hall.**

(30) Priorité : **27.06.89 FR 8908561**

(43) Date de publication de la demande :
**02.01.91 Bulletin 91/01**

(45) Mention de la délivrance du brevet :
**31.08.94 Bulletin 94/35**

(84) Etats contractants désignés :
**DE GB NL**

(56) Documents cités :
**WO-A-86/06878
FR-A- 2 578 343
US-A- 4 179 719
US-A- 4 584 552
PATENT ABSTRACTS OF JAPAN vol. 5, no.
122 (P-074) 07 août 1981, & JP-A-56 061022
(OLYMPUS KOGAKU KOGYO K.K.) 26 mai
1981,**

(73) Titulaire : **THOMSON-CSF
173, Boulevard Haussmann
F-75008 Paris (FR)**

(72) Inventeur : **Friederich Alain
THOMSON-CSF,
SCPI,
Cédex 67
F-92045 Paris la Défense (FR)**
Inventeur : **Creuzet, Gérard
THOMSON-CSF,
SCPI,
Cédex 67
F-92045 Paris la Défense (FR)**

(74) Mandataire : **Ruellan-Lemonnier, Brigitte et al
THOMSON-CSF,
SCPI,
B.P. 329,
50, rue Jean-Pierre Timbaud
F-92402 Courbevoie Cédex (FR)**

# Description

La présente invention concerne les têtes de lecture d'enregistrement magnétique, plus particulièrement les têtes de lecture mono ou multi-pistes utilisant l'effet Hall.

Actuellement, les têtes de lecture d'enregistrement magnétique mono ou multi-pistes sont en général réalisées en utilisant comme matériaux des matériaux tels que le permalloy, à savoir un alliage ferronickel à 78% de nickel (cf. FR-A-2578 343). Or, l'un des principaux inconvénients de ces têtes magnétiques concerne le bruit. Ce bruit est dû principalement aux caractères en domaines de l'aimantation. En effet, les alliages dans lesquels sont réalisées les têtes de lecture ne sont pas mono-cristallins. Ainsi, la présente invention a pour but de proposer une nouvelle structure pour les têtes de lecture d'enregistrement magnétique à effet Hall permettant d'obtenir un mono-cristal, de manière à résoudre le problème cidessus.

En conséquence, la présente invention a pour objet une tête de lecture magnétique à effet Hall, caractérisée en ce que l'élément actif de la tête comprend un substrat sur lequel sont épitaxiées une couche d'un matériau semiconducteur à forte mobilité électronique et une multicouche métallique magnétique constituée par des couches empilées de matériaux magnétiques et de matériaux non-magnétiques, et des électrodes d'amenée de courant et de détection de tension Hall en contact avec la couche de matériau semiconducteur, la couche de matériau semiconducteur et la multicouche étant isolées électriquement l'une de l'autre, la multicouche étant à anisotropie perpendiculaire et présentant une épaisseur comprise entre 100 et 1000 Å.

En épitaxiant la multicouche métallique magnétique sur le matériau semiconducteur, on obtient ainsi un mono-cristal. L'aimantation de cette structure est donc une aimantation mono-domaine qui entraîne une limitation du bruit.

D'autre part, pour que la structure ci-dessus puisse être utilisée comme tête de lecture magnétique, la multi-couche est à anisotropie perpendiculaire. De plus, elle présente une épaisseur globale comprise entre 100 et 1000 Å. Ainsi, en utilisant l'anisotropie d'interface et en réalisant des multi-couches avec des épaisseurs de couches individuelles suffisamment petites, on obtient une aimantation perpendiculaire à la multi-couche particulièrement favorable à l'utilisation de cette multi-couche comme tête de lecture.

Dans la structure ci-dessus, on obtient une concentration des lignes de flux due principalement à la multi-couche à aimantation perpendiculaire. Cette concentration des lignes de flux génère un champ magnétique dans la couche semiconductrice sur laquelle elle est épitaxiée. Il est alors possible de détecter les modifications de la tension Hall induite dans la couche semiconductrice lors des modifications d'aimantation d'un support d'enregistrement magnétique tel qu'une bande magnétique.

Selon une autre caractéristique de l'invention, pour ne pas perturber la détection de la tension Hall, la tête de lecture magnétique à effet Hall comporte de plus une couche isolante entre la couche en matériau semiconducteur et la multi-couche. Cette couche isolante est réalisée, de préférence, en oxyde isolant ou en un matériau semiconducteur à hauteur de bande importante telle que GaAlAs. Les têtes de lecture magnétiques à effet Hall ne comportant pas de couches isolantes sont réalisées avec des matériaux tels que la diode Schottky formée entre la multi-couche et la couche semiconductrice ne fuit pas. En conséquence, il devra y avoir une hauteur de barrière suffisante entre la première couche métallique de la multi-couche et la couche en matériau semiconducteur.

D'autres caractéristiques et avantages de la présente invention apparaîtront à la lecture de la description faite ci-après de divers modes de réalisation d'une tête de lecture magnétique à effet Hall avec référence aux dessins ci-annexés et dans lesquels :

- la figure 1 est une vue en perspective schématique d'un mode de réalisation d'une tête de lecture magnétique à effet Hall mono-piste ;
- la figure 2 est une vue en coupe par A-A de figure 1 ;
- la figure 3 est une vue en coupe similaire à celle de la figure 2 d'un autre mode de réalisation d'une tête magnétique à effet Hall conforme à la présente invention ;
- la figure 4 est une vue en plan de dessus montrant la disposition des contacts ;
- les figures 5A et 5B sont des vues schématiques expliquant le fonctionnement des têtes de lecture conformes à la présente invention ;
- la figure 6 est une vue donnant la gamme des signaux de tension Hall en fonction de l'aimantation de la bande lue par la tête de lecture, et
- la figure 7 est une vue en perspective schématique d'une tête de lecture à effet Hall multi-pistes conforme à la présente invention.

Dans les figures, pour simplifier la description les mêmes éléments portent les mêmes références. D'autre part, pour faciliter la compréhension des figures, les différentes épaisseurs des couches ont été agrandies.

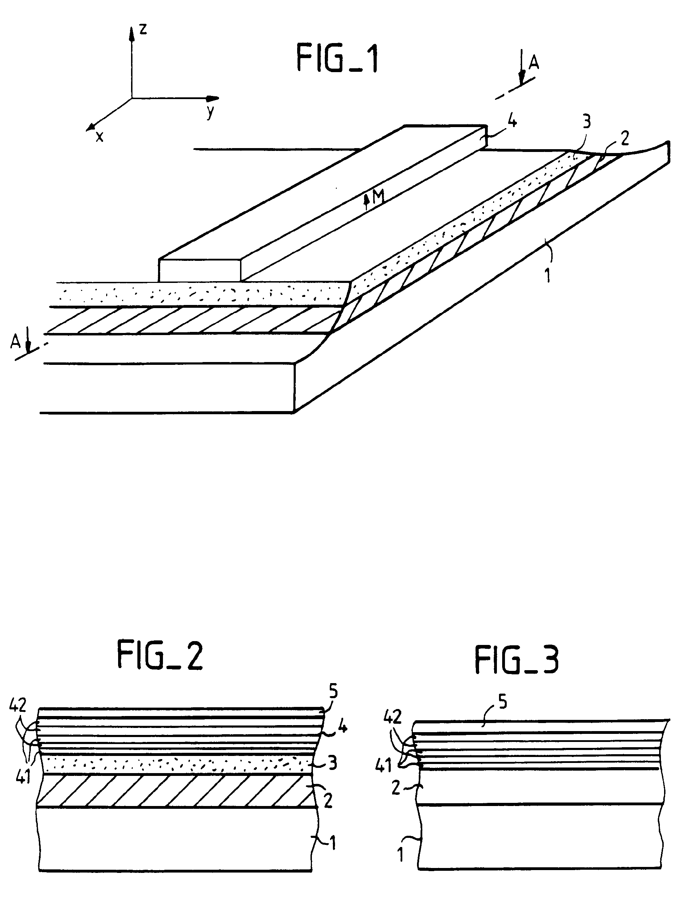

Comme représenté sur la figure 1, une tête de lecture magnétique à effet Hall conforme à la présente invention est constituée essentiellement d'un substrat 1 sur lequel ont été épitaxiées successivement une couche 2 en un matériau semiconducteur à forte mobilité électronique, une couche isolante 3 et une multi-couche 4 constituée par des couches empilées de matériaux magnétiques et de matériaux non magnétiques. Pour obtenir une structure monocristal permettant de réduire le bruit, la structure ci-dessus est réalisée en utilisant des techniques d'épitaxie spécifiques telles que l'épitaxie par jets moléculaires. D'autre part, le substrat 1 est choisi de manière à ce que les paramètres de maille soient compatibles avec les matériaux à déposer afin de pouvoir réaliser l'épitaxie. Le matériau semiconducteur à forte mobilité électronique est choisi parmi les composés des groupes III et V de la classification périodique des éléments tels que l'arseniure de gallium (GaAs) ou par du silicium dopé.

Ainsi, une structure possible pour la tête des figures 1 et 2 est formée d'un substrat 1 en arseniure de gallium non dopé et d'une couche 2 en arseniure de gallium dopé de manière à obtenir la mobilité électronique désirée. La couche isolante 3 peut être réalisée dans ce cas par un matériau semiconducteur à hauteur de barrière importante, telle que, par exemple GaAlAs. D'autres types de couches isolantes peuvent être utilisés, notamment des couches isolantes à base d'oxyde. La multi-couche magnétique 4 qui forme la partie active de la tête de lecture doit pouvoir permettre une transcription de l'information figurant sur l'enregistrement magnétique selon une aimantation perpendiculaire à ladite multi-couche. En conséquence, cette multi-couche magnétique 4 est constituée d'un empilement de couches magnétiques et de couches non magnétiques, les couches magnétiques 41 étant réalisées de préférence en cobalt ou en un alliage de cobalt tandis que les couches non magnétiques 42 sont réalisées en chrome, en argent ou en un alliage de ces métaux. De plus, les épaisseurs des couches individuelles sont suffisamment petites et présentent une épaisseur comprise entre quelques angströms et 30 à 60 Å chacune de manière à obtenir une multi-couche présentant une épaisseur comprise entre 100 et 1000 Å.

Ainsi, en utilisant l'anisotropie d'interface entre les couches de la multi-couche et du fait de l'épaisseur de cette multicouche, on obtient donc une aimantation perpendiculaire à la multicouche qui permet de l'utiliser pour la lecture d'un support d'enregistrement magnétique.

En fait, la structure de la multicouche utilisée doit être à anisotropie perpendiculaire, avec une énergie d'anisotropie

$$E_a = K_{eff} \sin^2 \theta, \text{ où } K_{eff} = K - 2\pi M^2$$

(K coefficient d'anisotropie), ou $\theta$ est l'angle entre l'aimantation et la normale à la multicouche, et M est l'aimantation. Le cycle d'hystérésis d'une telle multicouche est essentiellement rectangulaire, le champ coercitif valant

$$H_c = 2 K_{eff}/M$$

Ce champ $H_c$ doit être suffisamment petit pour que l'aimantation de la multicouche se renverse sous l'action du champ créé par l'enregistrement, quand on passe d'un domaine donné au domaine inverse dans celui-ci (en pratique $H_c \simeq 100$ à 500 0e selon le type d'enregistrement). L'épaisseur t de la multicouche doit être suffisamment petite pour que son action sur l'enregistrement soit négligeable, et ne modifie pas ce dernier (soit $tMH_c \ll t'M'H_c'$ où t', M' et $H_c'$ sont respectivement l'épaisseur, l'aimantation et le champ coercitif de la bande magnétique).

Selon un autre mode de réalisation de la présente invention, la couche isolante 3 prévue entre la couche semiconductrice 2 et la multi-couche 4 peut être supprimée. Dans ce cas, la multi-couche est épitaxiée directement sur la couche semiconductrice. Cependant, il est nécessaire que la diode SCHOTTKY ainsi obtenue ne fuit pas, ce qui implique que la hauteur de barrière entre la première couche magnétique de la multi-couche 4 et la couche semiconductrice 2 soit suffisante.

Cette isolation est nécessaire pour ne pas perturber la détection de l'aimantation de la multi-couche par mesure de l'effet Hall induit dans la couche semiconductrice comme cela sera expliqué de manière plus détaillée ci-après.

D'autre part, comme représenté sur les figures 2 et 3, la multi-couche 4 peut être recouverte d'une couche de protection 5. Cette couche de protection 5 est constituée soit par une couche à base de nitrure ou par une couche non magnétique anti-abrasion.

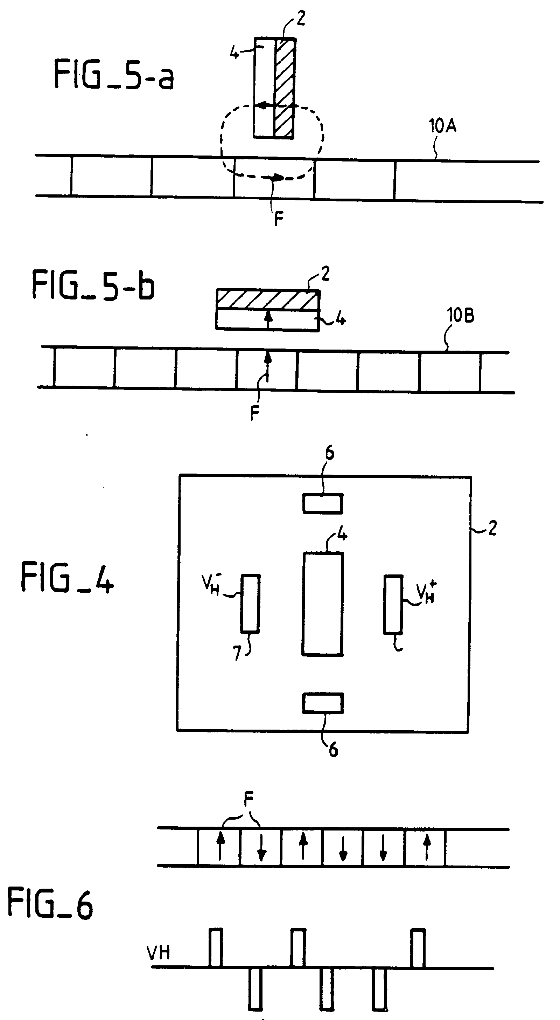

Comme représenté sur la figure 4, la tête de lecture est munie de deux paires d'électrodes 6,6 et 7,7 destinées respectivement à l'arrivée du courant et aux prises de tension Hall VH- et VH+. Ces électrodes sont réalisées par dépôt d'une couche métallique sur la surface de la couche semiconductrice 2. Dans le cas d'une tête de lecture comportant une couche isolante, il est nécessaire de graver la couche isolante. Après gravure, des contacts de très faible résistance sont déposés sur la couche semiconductrice 2.

Comme représenté sur les figures 5A et 5B, une tête de lecture conforme à la présente invention peut être utilisée aussi bien pour la lecture d'une bande 10 A à enregistrement longitudinale comme représenté sur la figure 5A que pour la lecture d'une bande 10B à enregistrement perpendiculaire comme représenté sur la figure 5B. Dans le premier cas, la tête de lecture est disposée perpendiculairement à la bande. Les lignes de flux sont alors orientées de la manière représentée par la ligne en tiretés, les deux flèches indiquant le sens de l'aimantation, respectivement dans la bande et dans la multicouche de la tête.

Dans le second cas, la tête de lecture est positionnée parallèlement à la bande.

Avec ce type de tête, la lecture est réalisée en combinant deux phénomènes, à savoir :

- une transcription de l'information figurant sur l'enregistrement magnétique en une aimantation perpendiculaire à la multi-couche, comme symbolisé par les flèches F sur les figures 5A et 5B ;
- une détection de l'aimantation de la multi-couche par la mesure de l'effet Hall induit dans la couche semiconductrice 2.

Comme représenté sur la figure 6, les informations binaires sont enregistrées dans la bande magnétique 10 par des aimantations de direction opposée symbolisées par les flèches F sur la bande 10. Cette alternance des domaines d'aimantation de la bande magnétique entraîne un changement de sens de l'aimantation dans la multi-couche métallique magnétique et donc un changement de signe de la tension de Hall VH mesurée dans la couche semiconductrice comme représenté sur la courbe de la figure 6. La tension Hall résultant du défilement de la bande sous la tête magnétique est donc une tension de type digital qui peut être facilement exploitée.

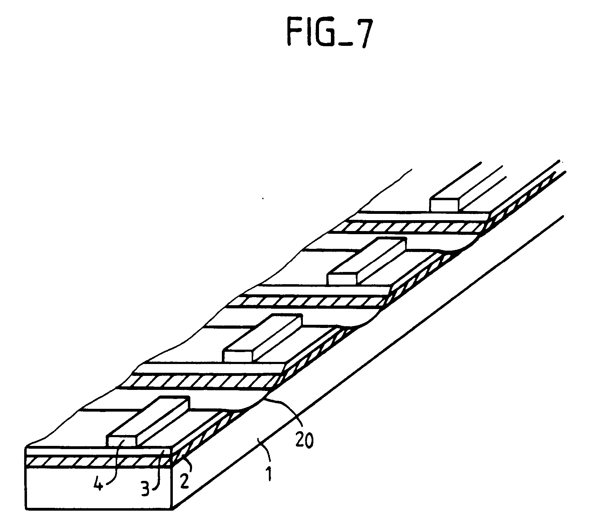

Comme représenté sur la figure 7, la structure de la tête de lecture décrite ci-dessus peut aussi être utilisée pour une tête de lecture multi-pistes. Dans ce cas, sur un substrat commun 1, on réalise une couche semiconductrice 2 revêtue d'une couche isolante 3 et d'une multi-couche 4. Pour réaliser des multi-pistes, on grave la multicouche, la couche isolante et la couche semiconductrice, la gravure 20 attaquant le substrat de manière à isoler les têtes les unes des autres.

Ainsi, en utilisant une structure multi-couche en remplacement des matériaux classiques de type permalloy et en sélectionnant les composants et les épaisseurs des couches magnétiques et non-magnétiques formant la multi-couche de manière à obtenir une anisotropie perpendiculaire donnant une aimantation perpendiculaire, ainsi qu'en utilisant un procédé spécifique de réalisation de la multi-couche de manière à obtenir un monocristal, on obtient une tête de lecture ayant une aimantation mono-domaine, ce qui permet de diminuer considérablement le bruit. On obtient aussi une tête de lecture donnant une détection de type digital de la tension de Hall induite.

## Revendications

1. Tête de lecture magnétique à effet Hall, caractérisée en ce que l'élément actif de la tête comprend un substrat (1) sur lequel sont épitaxiées une couche (2) d'un matériau semiconducteur à forte mobilité électronique et une multicouche (4) métallique magnétique constituée par des couches empilées de matériaux magnétiques (41) et de matériaux non-magnétiques (42) et des électrodes d'amenée de courant et de détection de tension Hall en contact avec la couche de matériau semiconducteur, la couche de matériau semiconducteur et la multicouche étant isolées électriquement l'une de l'autre, la multi-couche étant à anisotropie perpendiculaire et présentant une épaisseur comprise entre 100 et 1000 Å.

2. Tête de lecture selon la revendication 1, caractérisée en ce que le matériau non-magnétique des couches constituant la multicouche est choisi parmi le chrome, l'argent ou un alliage de ces métaux.

3. Tête de lecture selon la revendication 1, caractérisée en ce que le matériau magnétique des couches constituant la multicouche est choisi parmi le cobalt ou un alliage de cobalt.

4. Tête de lecture selon la revendication 1, caractérisée en ce que le matériau semiconducteur à forte mobilité électronique est choisi parmi les composés des groupes III et V de la classification périodique des éléments tels que GaAs.

5. Tête de lecture selon la revendication 1, caractérisée en ce que le matériau semiconducteur à forte mobilité électronique est constitué par du silicium dopé.

6. Tête de lecture selon la revendication 1, caractérisé en ce que le substrat est réalisé en un matériau permettant l'accrochage de la couche semiconductrice.

7. Tête de lecture selon la revendication 6, caractérisée en ce que le substrat est réalisé dans le même matériau que le matériau de la couche semiconductrice mais celui-ci étant non dopé.

8. Tête de lecture selon la revendication 1, caractérisée en ce que le substrat, la couche de matériau semiconducteur et la multicouche sont réalisés en des matériaux présentant des paramètres de maille compatibles.

9. Tête de lecture selon l'une quelconque des revendications 1 à 8, caractérisée en ce qu'elle comporte de plus une couche isolante (3) entre la couche (2) en matériau semiconducteur et la multicouche (4).

10. Tête de lecture selon la revendication 9, caractérisée en ce que la couche isolante est réalisée en oxyde isolant ou en un matériau semiconducteur à hauteur de bande importante tel que GaAlAs.

11. Tête de lecture selon l'une quelconque des revendications 1 à 10, caractérisée en ce que la multicouche (4) est recouverte d'une couche de protection (5).

12. Tête de lecture selon la revendication 11, caractérisée en ce que la couche de protection est constituée par une couche à base de nitrure ou par une couche non-magnétique anti-abrasion.

**13.** Tête de lecture selon l'une quelconque des revendications 1 à 12, caractérisée en ce qu'au moins la couche semiconductrice et la multicouche sont réalisées par épitaxie par jets moléculaires.

**14.** Tête de lecture multipistes, caractérisée en ce qu'elle est constituée de plusieurs têtes de lecture selon l'une quelconque des revendications 1 à 13, réalisées sur un substrat commun et séparées l'une de l'autre par gravure (20).

**Patentansprüche**

**1.** Magnetischer Lesekopf mit Hall-Effekt, dadurch gekennzeichnet, daß das aktive Element des Kopfes versehen ist mit einem Substrat (1), auf dem durch epitaktisches Wachstum eine Schicht (2) aus einem Halbleitermaterial mit hoher Elektronenbeweglichkeit sowie eine magnetische, metallische Mehrfachschicht (4) erzeugt worden sind, welche durch übereinandergestapelte Schichten von magnetischen Materialien (41) und nichtmagnetischen Materialien (42) gebildet ist, und mit Stromzufuhr- und Hallspannungs-Erfassungselektroden, die mit der Schicht aus Halbleitermaterial in Kontakt sind, wobei die Schicht aus Halbleitermaterial und die Mehrfachschicht elektrisch voneinander isoliert sind, wobei die Mehrfachschicht eine senkrechte Anisotropie und eine Dicke zwischen 100 und 1000 Å besitzt.

**2.** Lesekopf gemäß Anspruch 1, dadurch gekennzeichnet, daß das nichtmagnetische Material der die Mehrfachschicht bildenden Schichten aus Chrom, Silber oder aus einer Legierung dieser Metalle gewählt ist.

**3.** Lesekopf gemäß Anspruch 1, dadurch gekennzeichnet, daß das magnetische Material der die Mehrfachschicht bildenden Schichten aus Cobalt oder einer Cobaltlegierung gewählt ist.

**4.** Lesekopf gemäß Anspruch 1, dadurch gekennzeichnet, daß das Halbleitermaterial mit hoher Elektronenbeweglichkeit aus Verbindungen der Gruppen III und V des Periodensystems der Elemente, etwa GaAs, gewählt ist.

**5.** Lesekopf gemäß Anspruch 1, dadurch gekennzeichnet, daß das Halbleitermaterial mit hoher Elektronenbeweglichkeit aus dotiertem Silizium gebildet ist.

**6.** Lesekopf gemäß Anspruch 1, dadurch gekennzeichnet, daß das Substrat aus einem Material verwirklicht ist, das das Haften der Halbleiterschicht erlaubt.

**7.** Lesekopf gemäß Anspruch 6, dadurch gekennzeichnet, daß das Substrat aus demselben Material wie das Material der Halbleiterschicht verwirklicht ist, jedoch nicht dotiert ist.

**8.** Lesekopf gemäß Anspruch 1, dadurch gekennzeichnet, daß das Substrat, die Schicht aus Halbleitermaterial und die Mehrfachschicht aus Materialien verwirklicht sind, die kompatible Gitterparameter besitzen.

**9.** Lesekopf gemäß einem der Ansprüche 1 bis 8, dadurch gekennzeichnet, daß er außerdem zwischen der Schicht (2) aus Halbleitermaterial und der Mehrfachschicht (4) eine Isolierschicht (3) enthält.

**10.** Lesekopf gemäß Anspruch 9, dadurch gekennzeichnet, daß die Isolierschicht aus isolierendem Oxid oder aus einem Halbleitermaterial mit großer Bandbreite wie etwa GaAlAs verwirklicht ist.

**11.** Lesekopf gemäß einem der Ansprüche 1 bis 10, dadurch gekennzeichnet, daß die Mehrfachschicht (4) mit einer Schutzschicht (5) überzogen ist.

**12.** Lesekopf gemäß Anspruch 11, dadurch gekennzeichnet, daß die Schutzschicht aus einer Schicht auf Nitridbasis oder aus einer nichtmagnetischen Antiabriebschicht gebildet ist.

**13.** Lesekopf gemäß einem der Ansprüche 1 bis 12, dadurch gekennzeichnet, daß wenigstens die Halbleiterschicht und die Mehrfachschicht mittels Molekularstrahl-Epitaxie verwirklicht sind.

**14.** Mehrspur-Lesekopf, dadurch gekennzeichnet, daß er aus mehreren Leseköpfen gemäß einem der Ansprüche 1 bis 13 gebildet ist, die auf einem gemeinsamen Substrat verwirklicht und voneinander durch Ätzung (20) getrennt sind.

**Claims**

**1.** Hall-effect magnetic reading head, characterized in that the active element of the head comprises a substrate (1) on which are epitaxially grown a layer (2) of a semiconductor material having a high electron mobility and a magnetic metallic multilayer (4) constituted by stacked layers of magnetic materials (41) and of non-magnetic materials (42) and current-supply and Hall-voltage-detection electrodes in contact with the layer of semiconductor material, the layer of semiconductor material and the multilayer being electrically isolated from each other, the multilayer having perpendicular anisotropy and having a thickness lying between 100 and 1000 Å.

2. Reading head according to Claim 1, characterized in that the non-magnetic material of the layers constituting the multilayer is chosen from chromium, silver or an alloy of these metals.

3. Reading head according to Claim 1, characterized in that the magnetic material of the layers constituting the multilayer is chosen from cobalt or a cobalt alloy.

4. Reading head according to Claim 1, characterized in that the semiconductor material having a high electron mobility is chosen from the compounds of the III and V Groups of the Periodic Table of the Elements, such as GaAs.

5. Reading head according to Claim 1, characterized in that the semiconductor material having a high electron mobility is constituted by doped silicon.

6. Reading head according to Claim 1, characterized in that the substrate is made of a material making possible the bonding of the semiconductor layer.

7. Reading head according to Claim 6, characterized in that the substrate is made in the same material as the material of the semiconductor layer, but this material being non-doped.

8. Reading head according to Claim 1, characterized in that the substrate, the layer of semiconductor material and the multilayer are made from materials having compatible unit-cell parameters.

9. Reading head according to any one of Claims 1 to 8, characterized in that it additionally comprises an insulating layer (3) between the layer (2) made of semiconductor material and the multilayer (4).

10. Reading head according to Claim 9, characterized in that the insulating layer is made from insulating oxide or from a semiconductor material having a wide band gap, such as GaAlAs.

11. Reading head according to any one of Claims 1 to 10, characterized in that the multilayer (4) is covered with a protective layer (5).

12. Reading head according to Claim 11, characterized in that the protective layer is constituted by a nitride-based layer or by an anti-abrasion non-magnetic layer.

13. Reading head according to any one of Claims 1 to 12, characterized in that at least the semiconductor layer and the multilayer are produced by molecular beam epitaxy.

14. Multitrack reading head, characterized in that it consists of several reading heads according to any one of Claims 1 to 13, produced on a common substrate and separated from each other by etching (20).

# FIG_1

# FIG_2

# FIG_3

FIG_5-a

10A

F

FIG_5-b

2

4

10B

F

6

FIG_4

$V_H^-$

4

2

$V_H^+$

7

6

F

FIG_6

VH

8

# FIG_7